# FASCICULE DE BREVET EUROPEEN

(11) **EP 0 833 346 B1**
(45) Date de publication et mention de la délivrance du brevet: **24.03.1999**
(21) Numéro de dépôt: 97470022.1
(22) Date de dépôt: 23.09.1997
(51) Int. Cl.: G11C 16/06, G11C 7/00

(54) **Mémoire à accès série avec sécurisation de l'écriture**
Serieller Zugriffsspeicher mit Schreibsicherung
Serial access memory with secured writing

(30) Priorité: 30.09.1996 FR 9612153
(43) Date de publication de la demande: 01.04.1998
(73) Titulaire: STMicroelectronics S.A., 94250 Gentilly (FR)
(72) Inventeur: Lopez, Joaquim Ramon, 57000 Metz (FR); Naura, David, 57000 Metz (FR)
(74) Mandataire: Schmit, Christian Norbert Marie

(56) Documents cités:
- US-A- 4 654 829
- "MOS Memory Databook" 1984 , NATIONAL SEMICONDUCTOR CORPORATION , SANTA CLARA, US XP002032598 * page 7-8 - page 7-17 *
- ANDREW MOORWOOD: "EEPROMs come of age with control and interface integration" NEW ELECTRONICS INCORPORATING ELECTRONICS TODAY., vol. 18, no. 14, 9 juillet 1985, LONDON GB, pages 87-90, XP002032597
- GUEULLE P: "LES E2PROM SERIE SECURISEES" ELECTRONIQUE RADIO PLANS, no. 548, 1 juillet 1993, pages 23-28, XP000377636

## Description

L'invention a pour objet une mémoire à accès série avec sécurisation de l'écriture. L'invention est particulièrement adaptée pour les mémoires à grille flottante et pour les mémoires programmables une seule fois.

Les cellules de mémoire à grille flottante, de type EPROM ou EEPROM, lorsqu'elles sont non-programmées sont dans un état intermédiaire entre un niveau logique "0" et un niveau logique "1". Pour écrire dans ces cellules, on utilise des tensions importantes pour déplacer les charges du niveau intermédiaire au niveau souhaité "0" ou "1". Pour pouvoir écrire à nouveau dans ces cellules, il est fortement conseillé de les effacer au préalable, c'est à dire de remettre les cellules mémoires au niveau intermédiaire. Pour les mémoires de type EPROM, cela se fait par exposition aux UV. Pour les mémoires de type EEPROM, cela se fait en utilisant des tensions un peu plus importantes que pour la programmation avec une polarisation différente.

Par ailleurs, ces mémoires à grilles flottantes sont souvent utilisées dans des dispositifs portables de cartes électroniques, notamment des cartes à puces. Or, les dispositifs de connexion ont tendance à subir une usure des plots de contact due à de fréquentes connexions et déconnexions. Cette usure des plots de contact a pour effet d'introduire des parasites important sur ces plots. Lorsqu'une lecture est erronée, il suffit de la refaire à nouveau pour avoir une bonne lecture. Par contre, dans le cas d'une écriture erronée, il n'est parfois pas possible de pouvoir y remédier.

Dans le cas d'une écriture, il est donc préférable de ne pas écrire des données erronées. En effet, les mémoires programmables une seule fois ne peuvent être reprogrammées. Les mémoires EPROM ont besoin d'une source d'UV pour être effacées. Les mémoires de type EEPROM utilisées sur les cartes à puces ne disposent pas systématiquement des pompes de charge nécessaires à une reprogrammation.

Les sources des écritures erronées dues à des parasites provenant des plots de contact se traduisent généralement par des impulsions positives ou négatives sur les bornes d'accès à la mémoire. Dans le cas de moires séries, les parasites peuvent affecter les données de manière directe ou indirecte. C'est à dire que les parasites peuvent affecter les données ou les signaux de contrôle de la mémoire, lui faisant réaliser des écritures de type aléatoire.

Une mémoire EEPROM à accès série est dévoilée dans "MOS Memory Databook" 1984, de NATIONAL SEMICONDUCTOR CORPORATION, SANTA CLARA, US XP 00 20 32598, pages 7-8 à 7-17. La mémoire dévoilée valide une écriture en mémoire lors d'un changement d'état du signal de sélection.

L'invention propose de remédier aux écritures de données erronées dues à la présence de parasites sur les signaux de contrôles. En effet, il est possible de ne pas écrire une donnée si l'on détecte une erreur dans la synchronisation des signaux de commande. Pour cela, on effectue une écriture qu'après avoir vérifié qu'un signal de sélection de la mémoire change après la réception des données.

L'invention a pour objet un procédé d'écriture dans une mémoire à accès série comprenant au moins une matrice de cellules mémoires, une borne d'entrée d'horloge recevant un signal d'horloge, une borne d'entrée de données recevant un nombre défini de bits de données en série et cadencés par le signal d'horloge et une borne de sélection recevant un signal de sélection, ledit procédé étant initialisé lors d'un changement d'état du signal de sélection, d'un premier état vers un deuxième état, caractérisé en ce que l'écriture dans la matrice de cellules mémoires se produit uniquement si le signal de sélection passe du deuxième état au premier état pendant une période du signal d'horloge qui se situe juste après que le dernier des bits de données ait été reçu.

Le contrôle s'effectuant à partir du signal de sélection et du signal d'horloge, cela supprime les erreurs dues aux parasites présents sur un seul signal des deux signaux et cela supprime également les erreurs dues à des parasites simultanément présents sur les deux signaux dans plus de 95% des cas.

Pour éviter d'avoir une désynchronisation des données par rapport aux deux signaux, le procédé est initialisé si un bit de démarrage, positionné dans un état prédéfini, est reçu sur la borne d'entrée de données au commencement d'une période d'horloge pendant laquelle se produit le changement d'état du signal de sélection du premier état vers le deuxième état. De plus, le bit de démarrage est suivi par une succession de bits espacés chacun d'une période d'horloge, ces bits correspondant à des instructions, à des adresses, et à des données.

L'invention a également pour objet une mémoire à accès série comprenant au moins une matrice de cellules mémoires une borne d'entrée d'horloge recevant un signal d'horloge, une borne d'entrée de données recevant un nombre défini de bits de données en série, une borne de sélection recevant un signal de sélection, et des moyens pour détecter les changements d'état du signal de sélection caractérisé en ce qu'il comporte des moyens de sécurisation pour autoriser l'écriture dans la matrice de cellules mémoires uniquement si le signal de sélection change d'état pendant une période du signal d'horloge qui se situe juste après que le dernier des bits de donnée ait été reçu.

Préférentiellement, on prévoit un système pour des mémoires pouvant travailler sur deux tailles de mots. Un même compteur peut être utilisé pour compter le nombre de bits pour les deux tailles de mots.

L'invention sera mieux comprise et d'autres avantages apparaîtront à la lecture de la description qui va suivre d'un mode de réalisation préféré non-limitatif, la description faisant référence aux dessins annexés parmi lesquels:
la figure 1 représente une réalisation préférée d'un circuit de contrôle d'écriture d'une mémoire à accès série selon l'invention,
les figures 2 et 3 représentent des détails du circuit de la figure 1,
les figures 4 et 5 représentent des chronogrammes de fonctionnement du circuit de la figure 1 selon deux modes de fonctionnement différents.

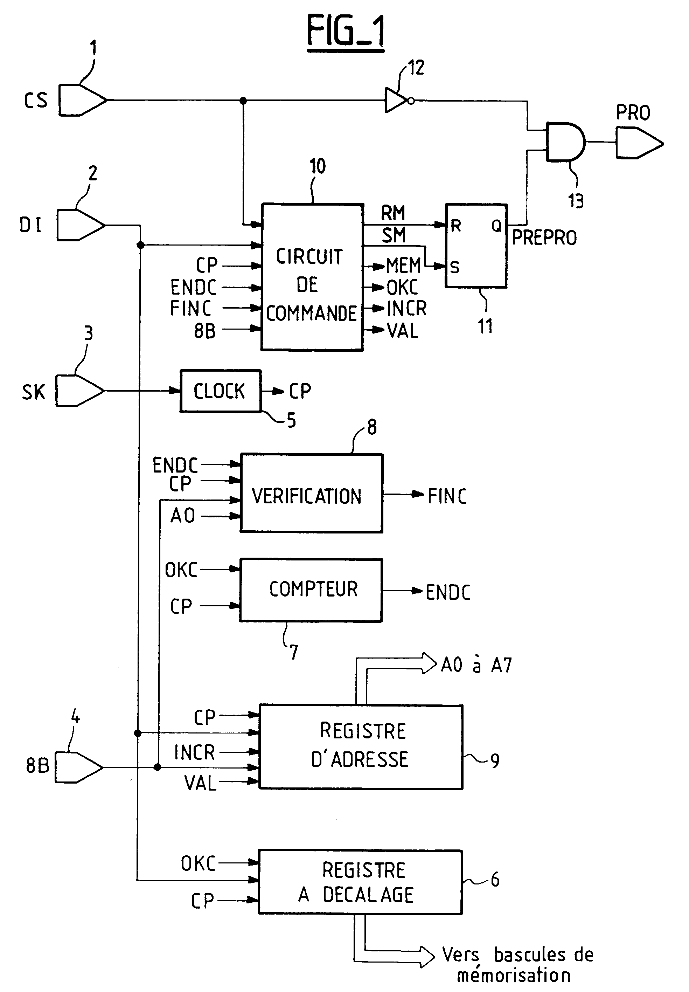

Le circuit de la figure 1 est contenu dans une puce de silicium. Cette puce de silicium étant une mémoire série comportant au moins une matrice de cellule mémoire constituant la mémoire principale du circuit. De plus, la puce contient les éléments classiques d'une mémoire à grille flottante, par exemple circuits de décodage de lignes et de colonnes, pompe de charge, amplificateur de lecture et d'écriture et circuit de séquencement. Le circuit de la figure 1 faisant partie du circuit de séquencement de la mémoire. Afin de clarifier cette figure 1, certaines connexions ne sont pas représentées et ont été remplacées par les noms des signaux.

Le circuit de la figure 1 comporte une première borne d'entrée 1, recevant un signal CS, une deuxième borne d'entrée 2, recevant un signal DI, une troisième borne d'entrée 3, recevant un signal SK, et une quatrième borne d'entrée 4, recevant un signal 8B. Ces quatres bornes d'entrée 1 à 4 correspondent dans la réalisation préférée à quatre plots de la puce de silicium. Le signal CS est un signal de sélection de puce qui dans notre exemple est actif à l'état "1". Préférentiellement, le signal DI est un signal d'entrée/sortie qui sert à convoyer des instructions, des adresses et des données entre la mémoire et l'extérieur. Le signal SK est un signal d'horloge généré par un dispositif externe à la puce. Le signal 8B indique un mode de fonctionnement de la mémoire qui correspond à la taille de mot des données, par exemple en 8 ou 16 bits. Dans un exemple, la quatrième borne d'entrée 4 est reliée soit à la masse soit à la tension d'alimentation de manière définitive au moment de l'encapsulation de la puce de silicium dans son boîtier (ou sur la carte à puce).

Un circuit de mise en forme d'horloge 5 possède une entrée, connectée à la troisième borne d'entrée 3, et une sortie. Ce circuit de mise en forme d'horloge 5 transforme le signal SK en signal impulsionnel CP adapté aux seuils des différents éléments synchrones de la mémoire. Un tel circuit peut être constitué par exemple d'un trigger et d'une monostable. Le circuit de mise en forme d'horloge a pour but de supprimer des parasites de petite amplitude présent sur le signal SK. Néanmoins, des parasites d'amplitude importante peuvent se transformer en impulsions sur le signal CP.

Un registre à décalage 6 possède une entrée série, connecté à la deuxième borne d'entrée 2, une entrée d'horloge, connectée à la sortie du circuit de mise en forme d'horloge 5, une entrée de validation et une sortie parallèle. Dans notre exemple, le registre à décalage 6 est un registre 8 bits, le contenu du registre étant visible en permanence sur la sortie parallèle. L'entrée de validation, recevant le signal OKC, sert à indiquer si le registre va décaler tout ses bits d'un cran et charger le bit présent à l'entrée série dans la cellule la plus proche de l'entrée série. La sortie parallèle est connectée à un bus qui permet de charger le contenu du registre à décalage dans des bascules de mémorisation servant de buffer à la matrice de cellule mémoire de la puce.

D'autres réalisations sont envisageables pour le registre à décalage 6. Celui-ci peut être bidirectionnel, c'est à dire qu'il peut être utilisé aussi bien pour les lectures que pour les écritures en mémoire. Si le circuit est monodirectionnel, l'entrée de validation peut également être supprimée, le registre effectuant alors des décalages en permanence.

Un compteur 7 possède une entrée d'horloge, connectée à la sortie du circuit de mise en forme 5, une entrée de validation, recevant le signal OKC, et une sortie, fournissant un signal ENDC. Le signal ENDC indique que le compteur 7 vient d'effectuer un tour complet. L'entrée de validation sert d'une part à initialiser le compteur 7 à zéro lorsqu'il est dans un premier état et à autoriser le comptage lorsqu'il est dans un deuxième état.

Un circuit de vérification 8 possède une entrée d'horloge, connectée à la sortie du circuit de mise en forme 5 afin de recevoir le signal CP, une entrée de fin de comptage, connectée à la sortie du compteur 7 afin de recevoir le signal ENDC, une entrée de mode, connectée à la quatrième borne d'entrée 4 afin de recevoir le signal 8B, une entrée de poids faible, recevant le bit d'adresse de poids le plus faible A0, et une sortie fournissant un signal FINC. Le circuit de vérification 8 sert à déterminer la fin de la réception des bits de données (lors d'une écriture) en fonction du mode de fonctionnement 8 bits ou 16 bits. Ce circuit de vérification 8 est décrit de manière plus précise ultérieurement.

Un registre d'adresse 9 possède une entrée d'horloge, connectée à la sortie du circuit de mise en forme 5 afin de recevoir le signal CP, une entrée série, connectée à la deuxième borne d'entrée 2 afin de recevoir le signal DI, une entrée d'incrémentation, recevant un signal INCR, une entrée de mode, connectée à la quatrième borne d'entrée 4 afin de recevoir le signal 8B, une entrée de validation, recevant le signal VAL, et une sortie parallèle, fournissant les bits d'adresse A0 à A7 sur des fils indépendants. Un des fils indépendants correspondant au bit de poids le plus faible A0 est connecté à l'entrée de poids faible du circuit de vérification 8. Tous les fils indépendants de la sortie parallèle sont connectés aux circuits de décodage de la mémoire (non représentés). Le signal CP sert à cadencer l'arrivée en série des bits dans le registre d'adresse 9. Le signal DI contient les bits d'adresse à rentrer dans le registre à un moment donné. Le signal VAL indique si le bit présent sur l'entrée série du registre d'adresse 9 est à rentrer dans ledit registre 9. Le signal 8B indique si l'adresse reçue correspond à une adresse de mémoire recevant des données de 8 bits ou des données de 16 bits. Le signal INCR sert à incrémenter le bit de poids le plus faible du registre d'adresse 9, correspondant à A0, lorsque l'on est en mode 16 bits. Un tel registre d'adresse 9 est décrit ultérieurement.

Un circuit de commande 10 possède une entrée de sélection, connectée à la première borne d'entrée 1 afin de recevoir le signal CS, une entrée d'instructions, connectée à la deuxième borne d'entrée 2 afin de recevoir le signal DI, une entrée d'horloge, connectée à la sortie du circuit de mise en forme 5 afin de recevoir le signal CP, une entrée de fin de comptage, connectée à la sortie du compteur 7 afin de recevoir le signal ENDC, une entrée de vérification, connectée à la sortie du circuit de vérification afin de recevoir le signal FINC, une entrée de mode de fonctionnement, connectée à la quatrième borne d'entrée 4 afin de recevoir le signal 8B, une sortie de fermeture de fenêtre, fournissant le signal RM, une sortie d'ouverture de fenêtre, fournissant un signal SM, une sortie de mémorisation, fournissant le signal MEM, une sortie de validation de comptage, connectée à l'entrée de validation du registre à décalage 6 et à l'entrée de validation du compteur 7 afin de fournir le signal OKC, une sortie d'incrémentation, connectée à l'entrée d'incrémentation du registre d'adresse 9 afin de fournir le signal INCR, et une sortie de validation d'adresse, connectée à l'entrée de validation du registre d'adresse afin de fournir le signal VAL. Le signal SM sert à déclencher l'ouverture d'une fenêtre temporelle autorisant l'écriture. Le signal RM sert à fermer la fenêtre temporelle autorisant l'écriture. Le signal MEM indique le chargement du contenu du registre à décalage 6 dans les bascules de mémorisation servant de buffer à la matrice de cellule mémoire de la puce. Le signal OKC autorise le fonctionnement du compteur 7. Le signal INCR indique l'incrémentation du bit de poids le plus faible A0 du registre d'adresse 9. Le signal VAL indique le moment de chargement du registre d'adresse 9. Le circuit de commande 10 est un séquenceur qu'il sera plus facile de comprendre à l'aide des chronogrammes décrits ultérieurement.

Une bascule de mémorisation 11, de type RS, possède une entrée de mise à zéro, connectée à la sortie de fermeture de fenêtre du circuit de commande 10 afin de recevoir le signal RM, une entrée de mise à un, connectée à la sortie d'ouverture de fenêtre du circuit de commande 10 afin de recevoir le signal SM, et une sortie, fournissant le signal PREPRO. Le signal PREPRO est un signal binaire pouvant prendre deux états. Arbitrairement, l'état "1" correspond à une autorisation d'écriture pendant une fenêtre temporelle donnée.

Un inverseur 12 possède une entrée, connectée à la première borne d'entrée 1 afin de recevoir le signal CS, et une sortie. Cet inverseur 12 sert à mettre en forme le signal CS pour pouvoir l'utiliser en validation d'écriture. Dans un exemple, on utilise un inverseur 12 à seuils.

Une porte logique 13 possède une première entrée, connectée à la sortie de l'inverseur 12, une deuxième entrée, connectée à la sortie de la bascule de mémorisation 11 afin de recevoir le signal PREPRO, et une sortie fournissant le signal PRO. Le signal PRO déclenche une séquence d'écriture établie de manière classique. Il est toutefois à noter que suivant l'organisation de la mémoire on effectue dans le cas de mots de 16 bits soit deux écritures successives dans une mémoire organisée en mots de 8 bits soit une écriture dans deux plans mémoires différents organisés en mots de 8 bits.

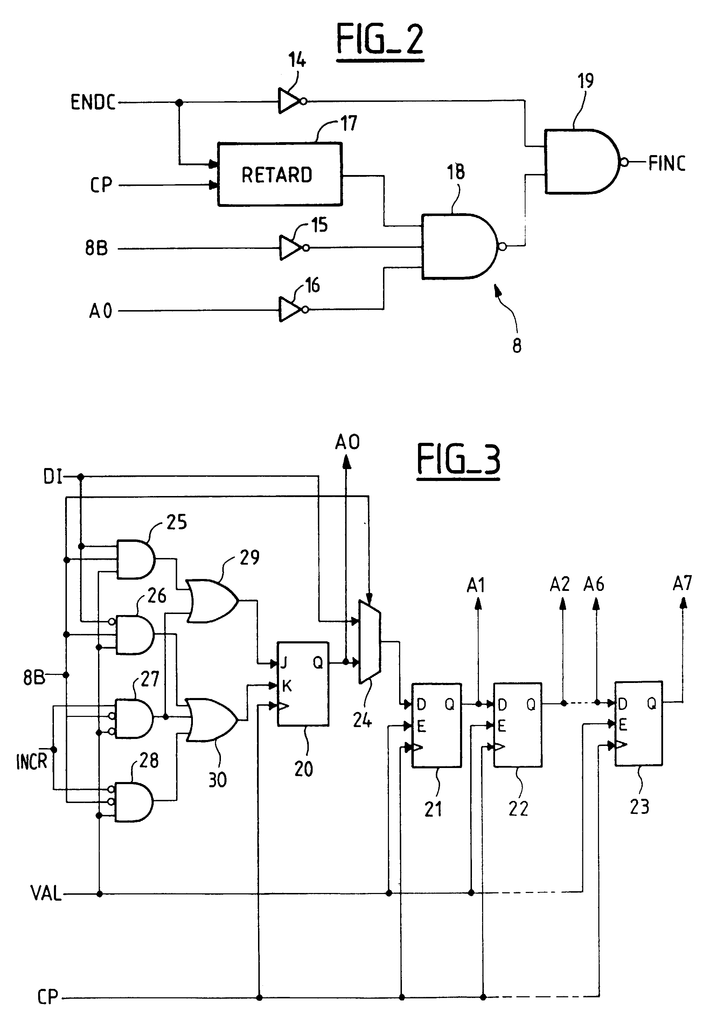

La figure 2 représente le circuit de vérification 8 utilisé dans la réalisation préférée de l'invention. Il ne s'agit que d'une possibilité de réalisation donnée uniquement à titre indicatif. Ce circuit de vérification 8 comporte des premier, deuxième et troisième inverseurs 14 à 16 ayant chacun une entrée et une sortie, un circuit retardateur 17 ayant deux entrées et une sortie, une première porte NON-ET 18 ayant trois entrées et une sortie, et une deuxième porte NON-ET ayant deux entrées et une sortie.

L'entrée du premier inverseur 14 correspond à l'entrée de fin de comptage du circuit de vérification 8. Une première entrée du circuit retardateur 17 correspond à l'entrée d'horloge du circuit de vérification 8. L'entrée du deuxième inverseur 15 correspond à l'entrée de mode du circuit de vérification 8. L'entrée du troisième inverseur 16 correspond à l'entrée de poids faible du circuit de vérification. La deuxième entrée du circuit retardateur 17 est connectée à l'entrée du premier inverseur 14. La sortie du premier inverseur 14 est connectée à la première entrée de la deuxième porte NON-ET 19. La sortie du circuit retardateur 17 est connectée à la première entrée de la première porte NON-ET 18. La sortie du deuxième inverseur 15 est connectée à la deuxième entrée de la première porte NON-ET 18. La sortie du troisième inverseur 16 est connectée à la troisième entrée de la première porte NON-ET 18. La sortie de la première porte NON-ET 18 est connectée à la deuxième entrée de la deuxième porte NON-ET 19. La sortie de la deuxième porte NON-ET correspond à la sortie du circuit de vérification 8 et produit le signal FINC.

Le circuit retardateur 17 sert à retarder le signal ENDC d'un cycle d'horloge. Une simple bascule de type D qui recevrait le signal CP sur son entrée d'horloge et le signal ENDC sur son entrée D convient parfaitement.

Dans le cas où le signal 8B est à "1", c'est à dire lorsque la mémoire fonctionne en mode 8 bits, la sortie du deuxième inverseur 15 est à "0". De ce fait, la sortie de la première porte NON-ET 18 est à "1". Si ENDC est à "0" alors la sortie du premier inverseur 14 est à "1", donc le signal FINC est à "0". Le signal FINC est le même que le signal ENDC (en négligeant les temps de propagation des différentes portes logiques).

Dans le cas où le signal 8B est à "0", c'est à dire lorsque la mémoire fonctionne en mode 16 bits, la sortie de la première porte NON-ET 18 dépend de ses première et troisième entrées. Si A0 est à "1", la troisième entrée de la première porte NON-ET est à "0" alors la sortie de la première porte logique est forcément à "1" impliquant que le signal FINC correspond au signal ENDC comme précédemment expliqué. Si par contre A0 est à "0" alors la sortie de la première porte NON-ET 18 est identique à la sortie du premier inverseur 14 mais avec un retard d'un cycle d'horloge; le signal FINC correspond alors au signal ENDC prolongé d'une période d'horloge.

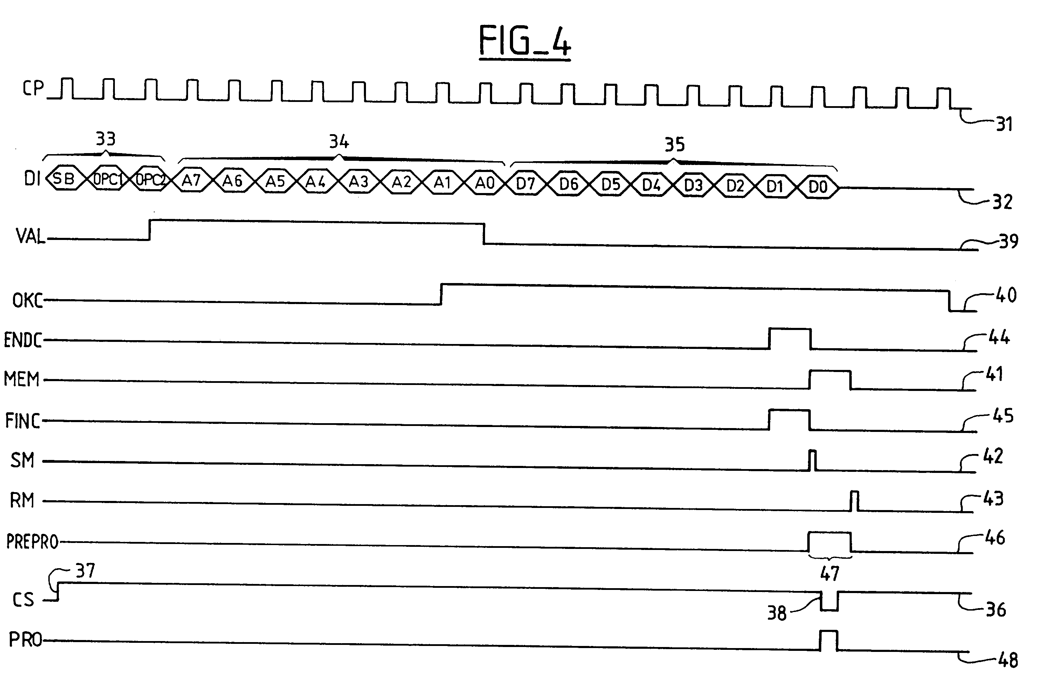

La figure 3 représente le registre d'adresse 9 utilisé dans la réalisation préférée de l'invention. Il ne s'agit que d'une possibilité de réalisation donnée uniquement à titre indicatif. Le registre d'adresse 9 comporte, dans l'exemple, huit bascules de mémorisation dont seulement quatre sont représentées sur la figure 3, respectivement les première, deuxième, troisième et huitième bascules 20 à 23. La première bascule de mémorisation 20 est de type JK et sert à mémoriser le bit de poids le plus faible de l'adresse, ledit bit de poids le plus faible pouvant provenir soit de l'extérieur, ou pouvant être généré par le registre d'adresse 9 suivant le mode de fonctionnement. La première bascule de mémorisation comporte une entrée J, une entrée K, une entrée d'horloge, et une sortie Q. Les deuxième à huitième bascules de mémorisation 21 à 23 sont identiques et sont de type D et servent à mémoriser les sept bits de poids le plus fort de l'adresse. Chacune des deuxième à huitième bascules de mémorisation 21 à 23 comporte une entrée de donnée D, une entrée de validation E, une entrée d'horloge, et une sortie Q. Le registre d'adresse 9 comporte en outre un multiplexeur 24, ayant des première et deuxième entrées de signal, une entrée de sélection et une sortie; des première à quatrième portes ET 25 à 28 ayant chacune des première à troisième entrées dont certaines sont inverseuses et une sortie; une première porte OU 29 ayant des première et deuxième entrées et une sortie; et une deuxième porte OU 30 ayant des première à troisième entrées et une sortie.

L'entrée d'horloge du registre d'adresse 9 est connectée à l'entrée d'horloge de chacune des bascules de mémorisation 20 à 23 afin de synchroniser toutes les bascules de mémorisation 20 à 23 entre elles. L'entrée série du registre 9 est connectée à la première entrée du multiplexeur 24, à la première entrée de la première porte ET 25, et à la première entrée qui est inverseuse de la deuxième porte ET 26. L'entrée d'incrémentation du registre d'adresse 9 est connectée à la première entrée de la troisième porte ET 27, et à la première entrée qui est inverseuse de la quatrième porte ET 28. L'entrée de mode du registre d'adresse 9 est connectée à l'entrée de sélection du multiplexeur 24, aux deuxièmes entrées des première et deuxième portes ET 25 et 26, et aux deuxièmes entrées qui sont inverseuses des troisième et quatrième portes ET 27 et 28. L'entrée de validation du registre d'adresse 9 est connectée aux troisièmes entrées des première, deuxième et quatrième portes ET 25, 26 et 28, à la troisième entrée qui est inverseuse de la troisième porte ET 27, et à chacune des entrées de validation E des deuxième à huitième bascules de mémorisation. La sortie parallèle du registre d'adresse 9 est constituée par l'ensemble des sorties des première à huitième bascules de mémorisation 20 à 23.

Par ailleurs, la sortie de la première porte ET 25 est connectée à la première entrée de la première porte OU 29. La sortie de la deuxième porte ET 26 est connectée à la première entrée de la deuxième porte OU 30. La sortie de la troisième porte ET 27 est connectée aux deuxièmes entrées des première et deuxième portes OU 29 et 30. La sortie de la quatrième porte ET 28 est connectée à la troisième porte OU 30. La sortie de la première porte OU 29 est connectée à l'entrée J de la première bascule de mémorisation 20. La sortie de la deuxième porte OU 30 est connectée à l'entrée K de la première bascule de mémorisation 20. La sortie Q de la première bascule de mémorisation est connectée à la deuxième entrée du multiplexeur 24. La sortie du multiplexeur 24 est connectée à l'entrée de donnée D de la deuxième bascule de mémorisation 21. Les sorties Q des deuxième à septième bascules de mémorisation 21 et 22 sont respectivement connectées aux entrées D des troisième à huitième bascules de mémorisation 22 et 23.

Le fonctionnement de ce registre d'adresse 9 dépend du mode de fonctionnement choisi. Si le signal 8B est à "1", c'est à dire si l'on travaille avec des mots de 8 bits, le multiplexeur 24 établit une connexion entre sa deuxième entrée et sa sortie, le signal INCR devient inutile et l'ensemble des portes ET 25 à 28, des portes OU 29 et 30, et de la première bascule de mémorisation 20 constitue une bascule équivalente à l'une des deuxième à huitième bascules de mémorisation 21 à 23. Tant que le signal VAL est actif, et à chaque front d'horloge, le bit présent à l'entrée de donnée du registre d'adresse 9 est rentré dans la première bascule de mémorisation 20, le bit qui était présent dans la première bascule est déplacé dans la première bascule, celui présent dans la deuxième bascule est décalé dans la troisième et ainsi de suite jusqu'à la huitième bascule. Lorsque le signal VAL est inactif, les bascules mémorisent leur contenu, laissant apparents et stables les bits A0 à A7 sur les fils de la sortie parallèle du registre.

Si le signal 8B est à "0", c'est à dire si l'on travaille avec des mots de 16 bits, alors le multiplexeur 24 établit une connexion entre sa première entrée et sa sortie, et l'ensemble des portes ET 25 à 28, des portes OU 29 et 30, et de la première bascule de mémorisation 20 constitue un compteur par deux. En effet, lorsque le signal VAL est actif, la première bascule de mémorisation est positionnée à "0" et le chargement s'effectue depuis l'entrée série du registre d'adresse 9 dans la deuxième bascule de mémorisation 21 puis dans les autres bascules jusqu'à la huitième bascule de mémorisation 23. Lorsque le signal VAL est inactif, alors le contenu des deuxième à huitième bascules est mémorisé et le contenu de la première bascule de mémorisation change d'état si pendant une période d'horloge le signal INCR est actif.

D'autres possibilités de réalisation permettent d'obtenir un registre d'adresse 9 ayant les mêmes fonctionnalités.

La figure 4 représente des chronogrammes correspondant à un mode de fonctionnement en 8 bits, le signal 8B étant positionné à "1". Ces chronogrammes permettront de mieux comprendre le fonctionnement de l'invention et aideront à la réalisation du circuit de commande 10.

La courbe 31 représente le signal CP, c'est à dire le signal d'horloge après mise en forme, ce signal CP étant normalement constitué d'impulsions identiques régulièrement espacées, les fronts montant de ce signal constituent les moments actifs dudit signal CP. La courbe 32 représente le signal DI qui est constitué d'un train de bits répartis en bits de contrôle 33, bits d'adresse 34, et bits de donnée 35. La courbe 36 représente le signal CS qui est constitué d'un front montant 37 indiquant le début de la sélection de la mémoire suivi d'un front descendant 38 devant valider l'écriture après l'envoi de tous les bits de donnée 35. Les signaux CP, DI et CS correspondent à des signaux produits de manière externe à la mémoire. Des courbes 39 à 43 correspondent respectivement aux signaux VAL, OKC, MEM, SM et RM, produits par le circuit de commande 10. Une courbe 44 correspond au signal de fin de comptage ENDC. Une courbe 45 correspond au signal FINC de fin de réception des bits de données. Une courbe 46 représente le signal PREPRO qui fait apparaître la fenêtre temporelle 47 autorisant une écriture. Une courbe 48 représente le signal PRO de déclenchement d'écriture.

A l'origine des temps des chronogrammes, le signal CS est à "0", on considère que la mémoire est en phase d'attente et que tous les signaux produits de manière internes à la mémoire sont à "0". Sur un premier coup d'horloge, on a un bit, par exemple à "1" qui correspond à l'état que doit avoir un bit de démarrage SB lors du changement d'état du signal CS de "0" à "1". Le signal CS étant maintenu à "1" jusqu'au prochain front actif de l'horloge, le circuit de commande va recevoir le reste des bits de contrôle 33 correspondant à une instruction de la mémoire. Dans l'exemple, on utilise deux bits OPC1 et OPC2. Lors de la réception du deuxième bit d'instruction OPC2, le circuit de commande positionne le signal VAL à "1" pour une durée de huit cycles d'horloge, comme représenté sur la courbe 39, afin de charger l'adresse A7 à A0 dans le registre d'adresse 9. Le circuit de commande 10 décode pendant ce temps l'instruction destinée à indiquer l'opération à effectuer dans la mémoire (lecture, écriture, test,...). On ne traitera par la suite que le cas où le code d'instruction OPC1 + OPC2 correspond à une écriture. Lorsque l'on charge l'avant dernier bit d'adresse A*1* dans le registre d'adresse 9, le circuit de commande 10 positionne à "1" le signal OKC qui déclenche le compteur 7 et qui autorise la réception des bits sur le registre à décalage 6. Au bout de huit cycles d'horloge, le compteur 7 indique la fin du comptage, pendant une période d'horloge, sur le signal ENDC. Le circuit de vérification fournit un signal FINC identique au signal ENDC. Le signal ENDC provoque le passage à "1" du signal MEM qui produit le chargement du contenu du registre à décalage 6 dans les bascules de mémorisation des buffers d'écritures. La descente simultanée des signaux ENDC et FINC provoque une brève impulsion sur le signal SM suivie au coup d'horloge suivant par une brève impulsion sur le signal RM. L'impulsion sur le signal SM fait basculer le signal PREPRO à l'état "1" et l'impulsion sur le signal RM fait basculer le signal PREPRO à l'état "0". Le signal PREPRO ouvre une fenêtre d'écriture 47 pendant une période d'horloge immédiatement après que le dernier des bits de données D0 ait été théoriquement reçu. Si le signal CS repasse à l'état "0" pendant que le signal PREPRO est à "1" alors le signal PRO passe à "1". Si le front montant du signal PRO ne correspond pas à un front montant d'horloge, alors on déclenche une séquence d'écriture qui va consister à produire une tension de programmation par pompage de charge puis à écrire à l'adresse présente dans le registre d'adresse la donnée qui est présente dans les bascules de mémorisation des buffers d'écriture.

Si un parasite important est présent sur le signal CS en dehors de la fenêtre d'écriture 47, aucune donnée n'est écrite. Si le signal CS ne change pas d'état pendant la fenêtre d'écriture 47 alors aucune donnée n'est écrite en mémoire. Si le front montant 37 du signal provient d'un parasite validé par une valeur du signal DI qui correspond à un bit de départ, il y a peu de chance qu'un front descendant 38 soit présent sur le signal CS pendant la fenêtre 47. Si un parasite important crée une impulsion d'horloge supplémentaire ou supprime une impulsion d'horloge, la fenêtre 47 va se trouver décalée par rapport au front 38 empêchant de ce fait l'écriture. Dans le cas où des parasites importants sont produits sur les deux signaux CP et CS de manière simultanée ou décalée de moins d'un cycle d'écriture, ce qui est rare, il est possible dans environ 5% des cas qu'une écriture erronée soit produite ce qui diminue considérablement les risques d'erreurs.

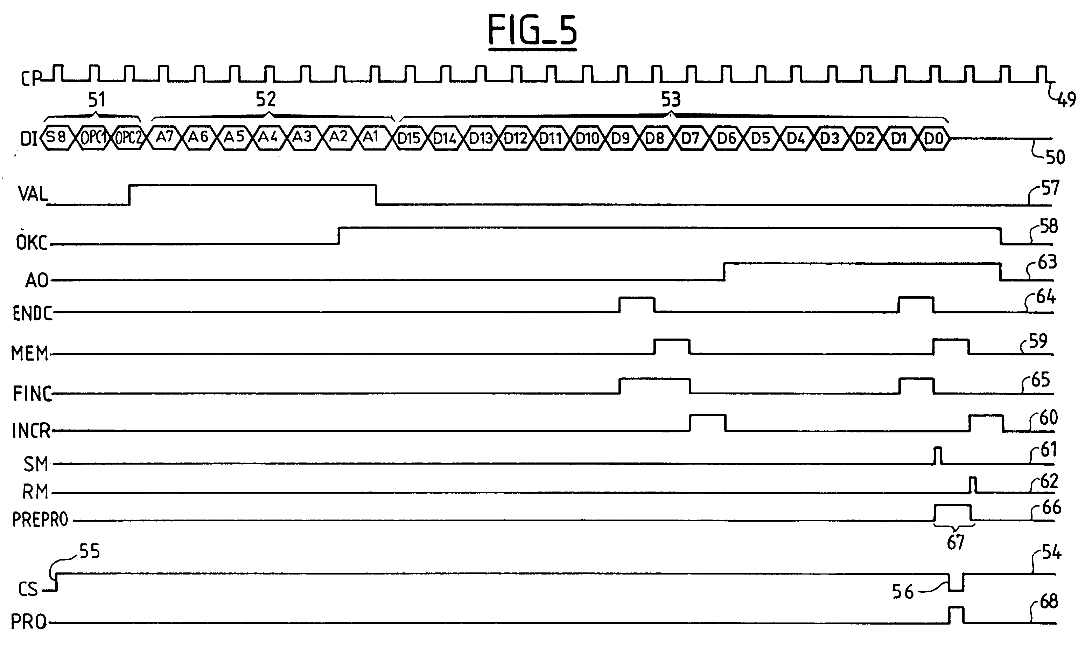

La figure 5 représente des chronogrammes correspondant à un mode de fonctionnement en 16 bits, le signal 8B étant positionné à "0". Ces chronogrammes permettront de mieux comprendre le fonctionnement de l'invention et aideront à la réalisation du circuit de commande 10.

La courbe 49 représente le signal CP, c'est à dire le signal d'horloge après mise en forme, ce signal CP étant normalement constitué d'impulsions identiques régulièrement espacées, les fronts montant de ce signal constituent les moments actifs dudit signal CP. La courbe 50 représente le signal DI qui est constitué d'un train de bits répartis en bits de contrôle 51, bits d'adresse 52, et bits de donnée 53. La courbe 54 représente le signal CS qui est constitué d'un front montant 55 indiquant le début de la sélection de la mémoire suivi d'un front descendant 56 devant valider l'écriture après l'envoi de tous les bits de donnée 53. Les signaux CP, DI et CS correspondent à des signaux produits de manière externe à la mémoire. Des courbes 57 à 62 correspondent respectivement aux signaux VAL, OKC, MEM, INCR, SM et RM, produits par le circuit de commande 10. Une courbe 63 correspond au bit de poids le plus faible du registre d'adresse 9. Une courbe 64 correspond au signal de fin de comptage ENDC. Une courbe 65 correspond au signal FINC de fin de réception des bits de données. Une courbe 66 représente le signal PREPRO qui fait apparaître la fenêtre temporelle 67 autorisant une écriture. Une courbe 68 représente le signal PRO de déclenchement d'écriture.

A l'origine des temps des chronogrammes, le signal CS est à "0", on considère que la mémoire est en phase d'attente et que tous les signaux produits de manière internes à la mémoire sont à "0". Sur un premier coup d'horloge, on a un bit, par exemple à "1" qui correspond à l'état que doit avoir un bit de démarrage SB lors du changement d'état du signal CS de "0" à "1". Le signal CS étant maintenu à "1" jusqu'au prochain front actif de l'horloge, le circuit de commande va recevoir le reste des bits de contrôle 51 correspondant à une instruction de la mémoire. Dans l'exemple, on utilise deux bits OPC1 et OPC2. Lors de la réception du deuxième bit d'instruction OPC2, le circuit de commande positionne le signal VAL à "1" pour une durée de sept cycles d'horloge, comme représenté sur la courbe 57, afin de charger l'adresse A7 à A1 dans le registre d'adresse 9. Le circuit de commande 10 décode pendant ce temps l'instruction destinée à indiquer l'opération à effectuer dans la mémoire (lecture, écriture, test,...). On ne traitera par la suite que le cas où le code d'instruction OPC1 + OPC2 correspond à une écriture. Lorsque l'on charge l'avant dernier bit d'adresse A2 dans le registre d'adresse 9, le circuit de commande 10 positionne à "1" le signal OKC qui déclenche le compteur 7 et qui autorise la réception des bits sur le registre à décalage 6. Au bout de huit cycles d'horloge, le compteur 7 indique la fin d'un premier comptage, pendant une période d'horloge, sur le signal ENDC. Le signal 8B étant à "0" et le bit de poids le plus faible A0 étant à "0" alors le circuit de vérification fournit un signal FINC prolongé d'une période d'horloge par rapport au signal ENDC. Le signal ENDC provoque le passage à "1" du signal MEM qui produit le chargement du contenu du registre à décalage 6 dans les bascules de mémorisation des buffers d'écritures. La descente non simultanée des signaux ENDC et FINC provoque une impulsion sur le signal INCR qui à pour but d'incrémenter A0 de "0" à "1", changeant ainsi l'adresse du prochain mot de huit bits reçu. Huit cycles d'horloge après avoir indiqué la fin d'un premier comptage, le compteur 7 indique la fin d'un deuxième comptage, pendant une période d'horloge, sur le signal ENDC. Le signal 8B étant à "0" et le bit de poids le plus faible A0 étant à "1" alors le circuit de vérification fournit un signal FINC identique au signal ENDC. Le signal ENDC provoque le passage à "1" du signal MEM qui produit le chargement du contenu du registre à décalage 6 dans les bascules de mémorisation des buffers d'écritures. La descente simultanée des signaux ENDC et FINC provoque une brève impulsion sur le signal SM suivie au coup d'horloge suivant par une brève impulsion sur le signal RM. L'impulsion sur le signal SM fait basculer le signal PREPRO à l'état "1" et l'impulsion sur le signal RM fait basculer le signal PREPRO à l'état "0". Le signal PREPRO ouvre une fenêtre d'écriture 47 pendant une période d'horloge immédiatement après que le dernier des bits de données D0 ait été théoriquement reçu. Si le signal CS repasse à l'état "0" pendant que le signal PREPRO est à "1" alors le signal PRO passe à "1". Si le front montant du signal PRO ne correspond pas à un front montant d'horloge, alors on déclenche une séquence d'écriture qui va consister à produire une tension de programmation par pompage de charge puis à écrire à l'adresse présente dans le registre d'adresse la donnée qui est présente dans les bascules de mémorisation des buffers d'écriture. L'écriture s'effectuant de manière simultanée ou successive suivant l'organisation physique de la mémoire.

si un parasite important est présent sur le signal CS en dehors de la fenêtre d'écriture 67, aucune donnée n'est écrite. Si le signal CS ne change pas d'état pendant la fenêtre d'écriture 67 alors aucune donnée n'est écrite en mémoire. Si le front montant 55 du signal provient d'un parasite validé par une valeur du signal DI qui correspond à un bit de départ, il y a peu de chance qu'un front descendant 56 soit présent sur le signal CS pendant la fenêtre 67. Si un parasite important crée une impulsion d'horloge supplémentaire ou supprime une impulsion d'horloge, la fenêtre 67 va se trouver décalée par rapport au front 56 empêchant de ce fait l'écriture. Dans le cas où des parasites importants sont produits sur les deux signaux CP et CS de manière simultanée ou décalée de moins d'un cycle d'écriture, ce qui est rare, il est possible dans environ 4% des cas qu'une écriture erronée se produise, ce qui diminue considérablement les risques d'erreurs.

De plus, l'écriture ne s'effectue que lorsque la totalité des bits sont reçus. Il n'est plus possible d'avoir des erreurs d'écriture dues à l'écriture en deux temps des mots de seize bits.

L'homme du métier pourra modifier certains éléments du mode de réalisation préféré sans changer l'objet de l'invention revendiquée. Ainsi le choix des différents niveaux logiques, et de ce fait des portes logiques est tout à fait arbitraire. de plus, certains signaux offrent certaines libertés par rapport à la forme montrée sur les chronogrammes, entre autre : A0, INCR, MEM, FINC, SM et RM.

Des variantes simples qui correspondent à la combinaison de l'invention avec l'état de la technique sont également envisageable. Par exemple, il est possible de choisir à l'aide d'un bit d'instruction supplémentaire, par exemple OPC3 si le mot à écrire (ou à lire) est codé sur 8 ou 16 bits. Dans ce cas, la quatrième borne d'entrée sera connectée à un registre de mémorisation du mode de fonctionnement qui pourra très bien faire partie du circuit de commande 10. Il est également possible d'avoir des systèmes à taille de mot fixe, ou à taille de mot variable multiple d'une taille définie pouvant être autre que huit bits.

Le bit de démarrage SB n'est pas nécessaire à l'invention mais permet de diminuer des risques éventuels de démarrage de séquence qui sont inutiles et peuvent ralentir la mémoire. Le choix de l'état du bit est purement arbitraire et peut même dans certain cas être remplacé par une succession de bits.

On peut également prendre en compte le signal CS pour valider le signal d'horloge afin de répercuter une erreur se produisant sur le signal de sélection sur le signal d'horloge. Dans ce cas, il n'est pas nécessaire de détecter la non coïncidence entre le front descendant du signal de sélection CS avec le signal d'horloge CP.

## Revendications

1. Procédé d'écriture dans une mémoire à accès série comprenant au moins une matrice de cellules mémoires, une borne d'entrée d'horloge (3) recevant un signal d'horloge (SK, CP), une borne d'entrée de données (2) recevant un nombre défini de bits de données (D15 à D0) en série qui sont cadencés par le signal d'horloge (CP), et une borne de sélection (1) recevant un signal de sélection (CS), ledit procédé étant initialisé lors d'un changement d'état du signal de sélection (CS), d'un premier état vers un deuxième état, caractérisé en ce que l'écriture dans la matrice de cellules mémoires se produit uniquement si le signal de sélection (CS) passe du deuxième état au premier état pendant la période du signal d'horloge (CP) qui se situe juste après que le dernier des bits de données (D0) ait été reçu.

2. Procédé selon la revendication 1, caractérisé en ce que le procédé est initialisé si un bit de démarrage (SB) positionné dans un état prédéfini, est reçu sur la borne d'entrée de données au commencement d'une période d'horloge pendant laquelle se produit le changement d'état du signal de sélection (CS) du premier état vers le deuxième état,
et en ce que le bit de démarrage est suivi par une succession de bits espacés chacun d'une période d'horloge, ces bits correspondant à des instructions (33 ou 51), à des adresses (34 ou 52), et à des données (35, 53, D15 à D0).

3. Procédé selon l'une des revendications 1 ou 2, caractérisé en ce que ledit nombre défini de bits peut prendre une première ou une deuxième valeur suivant l'état d'un bit de mode (8B) contenu dans la mémoire lors de la réception des données, la deuxième valeur correspondant au double de la première valeur.

4. Procédé selon l'une les revendications 1 à 3, caractérisé en ce que la mémoire compte les bits à l'aide d'un compteur (7) recevant le signal d'horloge (CP) afin de déterminer quel bit de donnée est le dernier des bits de données.

5. Procédé selon les revendication 3 et 4, caractérisé en ce que si le nombre défini prend la première valeur, alors le compteur (7) effectue un tour de compteur complet et en ce que si le nombre défini prend la deuxième valeur alors le compteur (7) effectue deux tours de compteur complet.

6. Mémoire à accès série comprenant au moins une matrice de cellules mémoires, une borne d'entrée d'horloge (3) recevant un signal d'horloge (SK), une borne d'entrée de données (2) recevant un nombre défini de bits de données (D15 à D0) en série qui sont cadencés par le signal d'horloge (CP) , une borne de sélection (1) recevant un signal de sélection (CS), et des moyens pour détecter les changements d'état du signal de sélection caractérisé en ce qu'il comporte des moyens de sécurisation (4 à 13) pour autoriser l'écriture dans la matrice de cellules mémoires uniquement si le signal de sélection (CS) change d'état pendant une période du signal d'horloge qui se situe juste après que le dernier des bits de donnée ait été reçu.

7. Mémoire selon la revendication 6, caractérisée en ce que la matrice de cellules mémoires est organisée en mots de bits d'une taille définie et en ce que les moyens de sécurisation comportent des moyens d'indication (4) pour indiquer que la borne de donnée (2) va recevoir des mots de la taille définie et des mots du double de la taille définie.

8. Mémoire selon la revendication 7, caractérisée en ce les moyens de sécurisation comportent :
- un compteur (7) par N qui reçoit le signal d'horloge (CP) et un signal de validation (CS) et qui fournit un signal de fin de comptage (ENDC) à chaque fois qu'il effectue un tour de compteur,
- des moyens de fenêtrage (11) pour positionner un signal de validation (PREPRO) dans un état de validation pendant une fenêtre temporelle (47 ou 67) qui dure une période d'horloge et qui commence immédiatement après avoir reçu le signal de fin de comptage d'un premier comptage si les moyens d'indication (8B) indiquent que la borne de donnée (2) va recevoir des mots de la taille définie, et immédiatement après avoir reçu deux signaux de fin de comptage successifs si les moyens d'indication (4) indiquent que la borne de donnée va recevoir des mots du double de la taille définie,
- une porte logique (13) ayant une première et une deuxième entrées et une sortie, la première entrée étant connectée à la borne de sélection (1) et la deuxième entrée étant connectée aux moyens de fenêtrage (11) pour recevoir le signal de validation (PREPRO), la sortie fournissant un signal d'écriture (PRO) dans un état d'autorisation si le signal de validation (PREPRO) est dans un état de validation pendant que le signal de sélection (CS) change d'état.

## Patentansprüche

1. Verfahren zum Schreiben in einen seriellen Zugriffsspeicher, der wenigstens eine Matrix von Speicherzellen aufweist, einen Takteingang (3), der ein Taktsignal (SK, CP) empfängt, einen Dateneingang (2), der eine definierte Anzahl von seriellen durch das Taktsignal (CP) getaktete Datenbits (D15 bis D0) empfängt, und einen Auswahlanschluß (1), der ein Auswahlsignal (CS) empfängt, aufweist, wobei das Verfahren initialisiert wird, wenn das Auswahlsignal (CS) von einem ersten Zustand in einen zweiten Zustand wechselt, dadurch gekennzeichnet, daß das Schreiben in die Matrix der Speicherzellen nur erfolgt, wenn das Auswahlsignal (CS) während der Periode des Taktsignals (CP) vom zweiten Zustand in den ersten Zustand wechselt, das direkt erfolgt, nachdem das letzte der Datenbits (D0) empfangen wurde.

2. Verfahren nach Anspruch 1, dadurch gekennzeichnet, daß das Verfahren initialisiert wird, wenn ein in einem vorbestimmten Zustand positioniertes Startbit am Dateneingang zu Beginn einer Taktperiode empfangen wird, in der der Wechsel des Auswahlsignals (CS) vom ersten Zustand zum zweiten Zustand erfolgt,
und daß das Startbit von einer Folge von Bits gefolgt ist, die jeweils um eine Taktperiode voneinander getrennt sind, wobei diese Bits Befehlen (33 oder 51), Adressen (34 oder 52) oder Daten (35, 53, D15 bis D0) entsprechen.

3. Verfahren nach einem der Ansprüche 1 oder 2, dadurch gekennzeichnet, daß die definierte Anzahl von Bits in Abhängigkeit des Zustands eines Modusbits (8B), das im Speicher beim Empfang der Daten enthalten ist, einen ersten oder zweiten Wert einnehmen kann, wobei der zweite Wert dem Doppelten des ersten Werts entspricht.

4. Verfahren nach einem der Ansprüche 1 bis 3, dadurch gekennzeichnet, daß der Speicher die Bits mit Hilfe eines Zählers (7) zählt, der das Taktsignal (CP) empfängt, um zu bestimmen, welches Datenbit das letzte der Datenbits ist.

5. Verfahren nach den Ansprüchen 3 und 4, dadurch gekennzeichnet, daß der Zähler (7) eine komplette Zählrunde ausführt, wenn die definierte Anzahl den ersten Wert einnimmt, und daß der Zähler (7) zwei gesamte Zählrunden ausführt, wenn die definierte Anzahl den zweiten Wert einnimmt.

6. Serieller Zugriffsspeicher mit wenigstens einer Matrix von Speicherzellen, einem Takteingang (3), der ein Taktsignal (SK) empfängt, einem Dateneingang (2), der eine definierte Anzahl von seriellen Datenbits (D15 bis D0) empfängt, die durch das Taktsignal (CP) getaktet sind, einem Auswahlanschluß (1), der ein Auswahlsignal (CS) empfängt, und Einrichtungen zur Detektion der Zustandsänderungen des Auswahlsignals, gekennzeichnet durch Sicherungseinrichtungen (4 bis 13), die das Schreiben in die Matrix der Speicherzellen nur erlauben, wenn das Auswahlsignal (CS) während einer Periode des Taktsignals den Zustand wechselt, das direkt erfolgt, nachdem das letzte Datenbit empfangen wurde.

7. Speicher nach Anspruch 6, dadurch gekennzeichnet, daß die Matrix der Speicherzellen in Wörter von Bits einer definierten Größe aufgebaut ist und daß die Sicherungseinrichtungen Anzeigeeinrichtungen aufweisen, die anzeigen, daß der Datenanschluß (2) Wörter der definierten Größe und Wörter mit dem Doppelten der definierten Größe empfangen wird.

8. Speicher nach Anspruch 7, dadurch gekennzeichnet, daß die Sicherungseinrichtungen aufweisen:
- einen Zähler (7) bis N, der das Taktsignal (CP) und ein Freigabesignal (CS) empfängt und ein Signal für das Ende der Zählung (ENDC) jedesmal nach Ausführung einer Zählrunde liefert,
- Fenstereinrichtungen (11), die ein Freigabesignal (PREPRO) für ein Zeitfenster (47 oder 67) in einem Freigabezustand positionieren, das eine Taktperiode dauert und das sofort beginnt, nachdem das Signal für das Ende der Zählung einer ersten Zählung empfangen wurde, wenn die Anzeigeeinrichtungen (8B) anzeigen, daß der Datenanschluß (2) Wörter der definierten Größe empfangen wird, und unmittelbar nachdem zwei aufeinanderfolgende Signale für das Ende der Zählung empfangen wurden, wenn die Anzeigeeinrichtungen (4) anzeigen, daß der Datenanschluß Wörter mit der doppelten Größe der definierten Größe empfangen wird,
- ein logisches Gatter (13) mit einem ersten und einem zweiten Eingang und einem Ausgang, wobei der erste Eingang an den Auswahlanschluß (1) angeschlossen ist und der zweite Eingang an die Fenstereinrichtung (11) angeschlossen ist, um das Freigabesignal (PREPRO) zu empfangen, wobei der Ausgang ein Signal zum Schreiben (PRO) in einen Genehmigungszustand liefert, wenn das Freigabesignal (PREPRO) in einem ersten Freigabezustand ist, während das Auswahlsignal (CS) den Zustand wechselt.

## Claims

1. A process for writing in a serial access memory comprising at least one matrix of memory cells, a clock input terminal (3) receiving a clock signal (SK, CP), a data input terminal (2) receiving a predetermined number of data bits (D15 to D0) in series, the cadence of which is set by the clock signal (CP), and a selection terminal (1) receiving a selection signal (CS), the said process being initiated when there is a change in state of the selection signal (CS) from a first state to a second state, characterised in that writing in the matrix of memory cells occurs only if the selection signal (CS) passes from the second state to the first state during the period of the clock signal (CP) which occurs immediately after the last of the data bits (DO) has been received.

2. A process according to claim 1, characterised in that the process is initiated if a starting bit (SB), placed in a predefined state, is received at the data input terminal at the commencement of a clock period during which the change of state of the selection signal (CS) from the first state to the second state occurs,
and in that the starting bit is followed by a succession of spaced bits, each with the duration of a clock signal period, the said bits corresponding to instructions (33 or 51), addresses (34 or 52) or data (35, 53, D15 to D0).

3. A process according to either claim 1 or claim 2, characterised in that the said predetermined number of bits may have a first or a second value depending on the state of a mode bit (8B) contained in the memory when the data is received, the second value being twice the first value.

4. A process according to any one of claims 1 to 3, characterised in that the memory counts the bits with the aid of a counter (7) receiving the clock signal (CP) in order to determine which data bit is the last of the data bits.

5. A process according to claims 3 and 4, characterised in that if the predetermined number has the first value, then the counter (7) performs a complete revolution of the counter and if the predetermined number has the second value the counter (7) performs two complete revolutions of the counter.

6. A serial access memory comprising at least one matrix of memory cells, a clock input terminal (3) receiving a clock signal (SK), a data input terminal (2) receiving a predetermined number of data bits (D15 to D0) in series, the cadence of which is set by the clock signal (CP), a selection terminal (1) receiving a selection signal (CS), and means for detecting the changes in state of the selection signal, characterised in that it contains security providing means (4 to 13) to authorise writing in the matrix of memory cells only if the selection signal (CS) changes state during a clock signal period occurring immediately after the last of the data bits has been received.

7. A memory according to claim 6, characterised in that the matrix of memory cells is organised in bit words of a predefined size and in that the security providing means comprise indicating means (4) for indicating that the data terminal (2) is about to receive words of the predefined size and words of twice the predefined size.

8. A memory according to claim 7, characterised in that the security providing means comprise:
- a times N counter (7) which receives the clock signal (CP) and a validation signal (CS) and which supplies an end of counting signal (ENDC) each time it performs a revolution of the counter,
- windowing means (11) for positioning a validation signal (PREPRO) in a validation state during a time window (47 or 67) which lasts for a clock period and which commences immediately after reception of the end of counting signal of a first counting if the indication means (8B) indicate that the data terminal (2) is about to receive words of the predefined size, and immediately after reception of two successive end of counting signals if the indication means (4) indicate that that the data terminal is about to receive words of twice the predefined size,
- a logic gate (13) having a first and a second inputs and an output, the first input being connected to the selection terminal (1) and the second input being connected to the windowing means (11) to receive the validation signal (PREPRO), and the output producing a write signal (PRO) in an authorisation state if the validation signal (PREPRO) is in a validation state when the selection signal (CS) changes state.
